# EUROPEAN PATENT SPECIFICATION

(11) **EP 4 220 959 B1**
(45) Date of publication and mention of the grant of the patent: **25.11.2026**
(21) Application number: 22305105.3
(22) Date of filing: 31.01.2022
(51) Int. Cl.: H03K 5/00, H03K 23/00

(54) **SINGLE-ENDED TO DIFFERENTIAL SIGNAL CONVERTER, AND SIGNAL CONVERTING METHOD**
EINFACHEND-DIFFERENZIALUMWANDLUNGSSCHALTUNG UND SIGNALUMWANDLUNGSVERFAHREN
CONVERTISSEUR DE SIGNAL ASYMÉTRIQUE-DIFFÉRENTIEL ET PROCÉDÉ DE CONVERSION DE SIGNAL

(43) Date of publication of application: 02.08.2023
(73) Proprietor: NXP B.V., 5656 AG Eindhoven (NL)
(72) Inventor: Dal Toso, Stefano, 5656 AG Eindhoven (NL); Susplugas, Olivier, 31023 Cedex 1 Toulouse (FR)
(74) Representative: Krott, Michel

(56) References cited:
- CN-A- 113 726 335
- KR-B1- 100 247 912
- WELP BENEDIKT ET AL: "A 1-30 GHz 3-bit vector modulator based on ultra-wideband IQ-generation for MIMO-radar-systems in SiGe BiCMOS", 2017 IEEE RADIO FREQUENCY INTEGRATED CIRCUITS SYMPOSIUM (RFIC), IEEE, 4 June 2017 (2017-06-04), pages 300 - 303, XP033115807, DOI: 10.1109/RFIC.2017.7969077

## Description

### TECHNICAL FIELD

The present disclosure relates to a signal converter device for converting a single-ended signal to a differential signal. Further, the present disclosure relates to a method of converting a single-ended signal to a differential signal. Thus, the present disclosure may refer to the technical field of signal conversion and signal processing.

### TECHNICAL BACKGROUND

A signal converter is a device that is configured to convert a first signal into a second signal, being different from the first signal. For example, a signal converter can be configured to convert a single-ended signal into a differential signal.

A Time to Digital Converter (TDC) is a device that quantifies the phase difference between an incoming signal S(t) and a reference signal Ref(t). In most of applications both, S(t) and Ref(t), are single-ended signals. Nevertheless, a differential incoming signal can permit an improved TDC performance in term of linearity and resolution. Many TDC implementations rely on a single-ended to differential signal converter to convert the single-ended incoming (CMOS) clock signal to a differential signal. However, such a single-ended to differential converter can again become a bottleneck for the TDC performance, due to a potentially low linearity and accordingly low Zero-Crossing (ZC) stability (ZC properties) of the single-ended to differential converter.

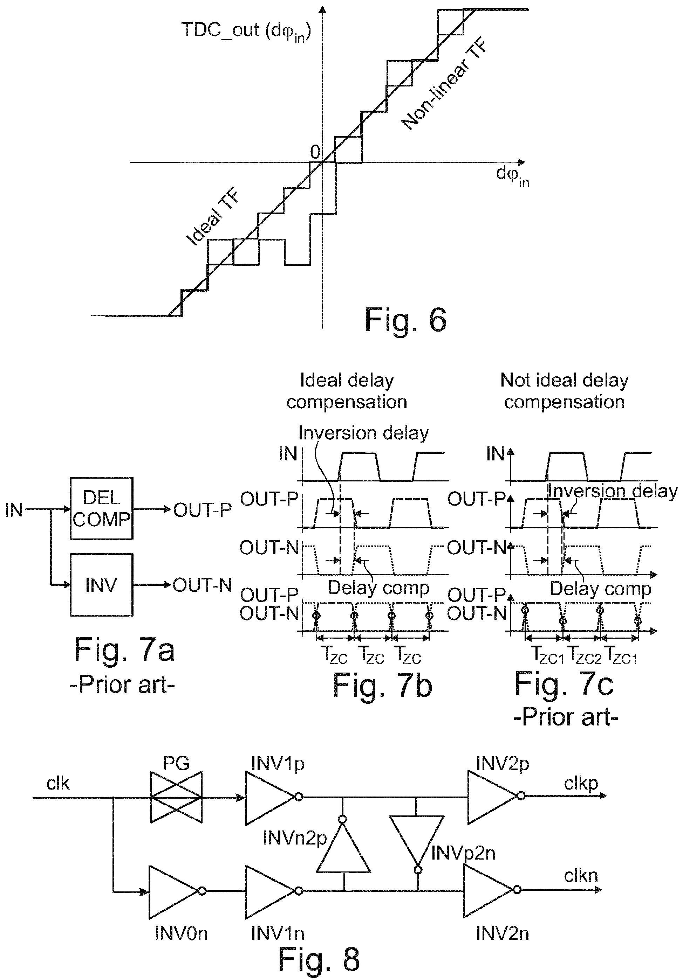

Due to non-idealities of the design (and especially due to non-stable ZC properties), the transfer function (TF) of the TDC can be non-linear, lowering or degrading the PLL or system performances in which the TDC is used (see **Figure 6****).**

Conventionally, the complementary phases of the differential signal are generated by inverting the incoming single-ended signal. The delay introduced by the inverting circuit is then compensated to guarantee stable ZC properties between the differential phases. Even though many different delay compensation techniques have been described, the compensation has not been ideal, leading to inaccurate ZC properties of the differential signal.

Documents CN113726335A and KR100247912B1 disclose such signal converter devices.

**Figure 7a** shows a conventional example, wherein the complementary phases of the differential signal are generated by inverting the input signal and compensating for the inversion delay. However, if the delay compensation is not ideal, the zero crossings of the differential signal are modulated. In case of ideal delay compensation, the zero crossing are equally spaced, with period TZC (see **Figure 7b****).** In case of not ideal compensation (which occurs for the conventional example), the zero crossing properties are not equally time spaced (TZC1 ≠ TZC2), as can be seen in **Figure 7c****.**

**Figure 8** shows a conventional approach in more detail, wherein differential signals are generated rail-to-rail. Inverters are coupled in series, and the opposite signal phase is built by inverting the input with an additional inverter (INV0n). Since the two paths are not symmetrical, a stable differential output ZC at half of the supply voltage is difficult to obtain. To stabilize the output ZC, it is further required to fine-tune the components of each path. A pass-gate (PG) can be used in series in the path lacking one inverter to balance the signals propagation speed. Further, in this example, additional resynchronization inverters INVp2n and INVn2p are used to force the two paths to work in phase opposition. Nevertheless, non-symmetries remain and the ZC properties of the differential outputs are still sensitive to process and mismatches.

### OBJECT AND SUMMARY OF THE DISCLOSURE

There may be a need to convert a single-ended signal to a differential signal in an efficient and robust manner, in particular with highly stable zero-crossing properties. A device and a method according to the independent claims are described in the following. Exemplary embodiments are described by the dependent claims.

According to an aspect of the present disclosure, there is described a signal converter device (for example being configured as or being part of a time-to-digital converter) for converting a single-ended signal (e.g. a clock signal) to a differential signal according to claim 1.

According to an aspect of the present disclosure, there is described a method of converting a single-ended signal to a differential signal according to claim 13.

According to an exemplary embodiment of the present disclosure, a single-ended signal may be converted to a differential signal in an efficient and robust manner (in particular with a highly stable zero-crossing output), when the single-ended input signal frequency is multiplied and subsequently divided (in particular based on a symmetrical system) to provide a differential output signal. This approach may overcome limitations of the prior art by having an optimized symmetry of the path that generates the differential signal(s). In particular, there may be no need to invert any signal or to compensate any delay, because the differential signal generation with high ZC precision may be guaranteed by the signal converter design (in particular the ideal symmetrical structure).

Conventionally, several tricks are applied in order to compensate for consequences of non-symmetries of a single-to-differential converter (see also discussion further above).
In contrast to these complex and error-prone approaches, it is described here for the first time a simple and easy-to-implement approach that is at the same time a true symmetrical design that reliably provides differential signals with a highly stable zero-crossing output.

The described approach may be efficiently applied in different electronic applications that relate to signal conversion. In particular, the linearity of a time-to-digital converter may be significantly improved.

### DESCRIPTION OF EXEMPLARY EMBODIMENTS

In the following, further exemplary embodiments of the device and the method will be explained.

According to an embodiment, the multiplier device is configured to multiply by two and/or a multiple of two (the input signal frequency). In the present context, the term multiplier device may refer to any circuit that is configured to multiply an incoming (clock) signal (frequency). The term multiple of two may refer to a product of the number two and a further natural number. Thus, the multiple of two may be for example be four, six, eight, etc.

According to a further embodiment, the divider device is configured to divide by two and/or the multiple of two. In the present context, the term divider device may refer to any circuit that is configured to divide an incoming (clock) signal and thereby providing a differential signal. In an example, a divider device may be a symmetrical differential device. In a further example, the number of multiplication and division is the same.

According to a further embodiment, at least one of the incoming signal, the multiplied signal, and the differential signal is a clock signal.

The multiplication is a frequency multiplication.

The division is a frequency division. In particular, the frequency of the single ended incoming signal and the differential output signal is the same.

According to a further embodiment, the multiplier device is further configured to provide a delayed incoming signal of the incoming signal, and include the delayed incoming signal in the multiplication. Thereby, a reliable multiplication operation may be established.

According to a further embodiment, the multiplier device further comprises an XOR-gate, wherein the input to the XOR-gate comprises the incoming signal and the delayed incoming signal, and wherein the output of the XOR-gate comprises the multiplied signal.

According to a further embodiment, the divider device comprises a differential flip-flop circuit, in particular a differential symmetrical flip-flop circuit. In this manner, the implementation may be straightforward using tested and established devices. The symmetrical design may in particular lead to a highly stable ZC output.

According to a further embodiment, the device is at least partially configured in CMOS. Thereby, the described concept may be implemented in an established and robust environment.

The signal converter device further comprises a synchronizer device (in particular coupled between the multiplier device and the divider device), and configured to i) provide a preset signal, and ii) synchronize at least one of the multiplied signal and the differential signal with respect to the preset signal. In an example, if no care is applied, the initial phase of some symmetrical divider implementation is unknow (it depends on the mismatch of some divider components). Hereby, implementing a preset function that forces the initial state of the divider outputs can solve this issue.

According to a further embodiment, the device further comprises a combiner (e.g. an , AND-gate), coupled in between the multiplier device and the divider device, wherein the synchronizer device is configured to provide a synchronization signal to the combiner to generate a synchronized multiplied signal. This implementation may be efficient to couple the preset signal into the multiplier-divider path.

According to a further embodiment, there is provided a time-to-digital converter that comprises the device as described above. By achieving a highly stable ZC output, linearity of the TDC may be improved.

### BRIEF DESCRIPTION OF THE DRAWINGS

Figure 1a illustrates a signal converter device and Figure 1b illustrates the corresponding signals according to an exemplary embodiment of the present disclosure.
Figure 2a illustrates a signal converter device in more detail and Figure 2b illustrates the corresponding signals according to an exemplary embodiment of the present disclosure.
Figure 3a illustrates a multiplier device and Figure 3b illustrates the corresponding signals according to an exemplary embodiment of the present disclosure.
Figure 4a illustrates a signal converter device with a synchronization device and Figure 4b illustrates the corresponding signals according to an exemplary embodiment of the present disclosure.
Figure 5a illustrates a basic implementation of the divider device, while Figure 5b illustrates a more detailed implementation of the divider device on transistor level according to an exemplary embodiment of the present disclosure.
Figure 6 illustrates a highly stable zero-crossing output according to an exemplary embodiment of the present disclosure in comparison with a conventional output.
Figures 7a and 7c illustrate a prior art conversion device with the corresponding signals, while Figure 7b illustrates the signals of a signal conversion device according to an exemplary embodiment of the present disclosure.
Figure 8 illustrates a conventional approach for signal conversion.

### DETAILED DESCRIPTION OF THE DRAWINGS

Before referring to the drawings, exemplary embodiments will be described in further detail, some basic considerations will be summarized based on which exemplary embodiments of the present disclosure have been developed.

According to an exemplary embodiment of the present disclosure, there is generated a differential signal by a fully differential sense-amplifier-based D-flip-flop which is used as a frequency divider by two. It requires then in-front a frequency multiplier by two, that receives the single-ended input signal, and provides a clock signal multiplied by two. Since the proposed approach does not rely on an inversion to generate the complementary phase, there is no additional delay which would have to be compensated. Thereby, the accuracy of a differential signal ZC precision is guaranteed by construction.

According to an exemplary embodiment of the present disclosure, there is described the usage of a differential frequency divider by two (e.g a differential flip-flop) with a frequency multiplier by two in front. A single-ended signal goes to the frequency multiplier by two, and the multiplier output signal is fed to a fully-differential frequency divider by two. The output of the fully differential divider is a differential signal at the same frequency as the original single-ended signal. Due to the fully differential implementation of the divider device, the two differential signal phases are exactly 180 degrees apart.

According to an exemplary embodiment of the present disclosure, a differential CMOS clock is generated by frequency multiplying by two the single-ended input signal, while the multiplied by two signal is then used as a clock for a differential (symmetrical) divide by two circuit. The output of the divider by two is the desired differential signal, which is differential by construction.

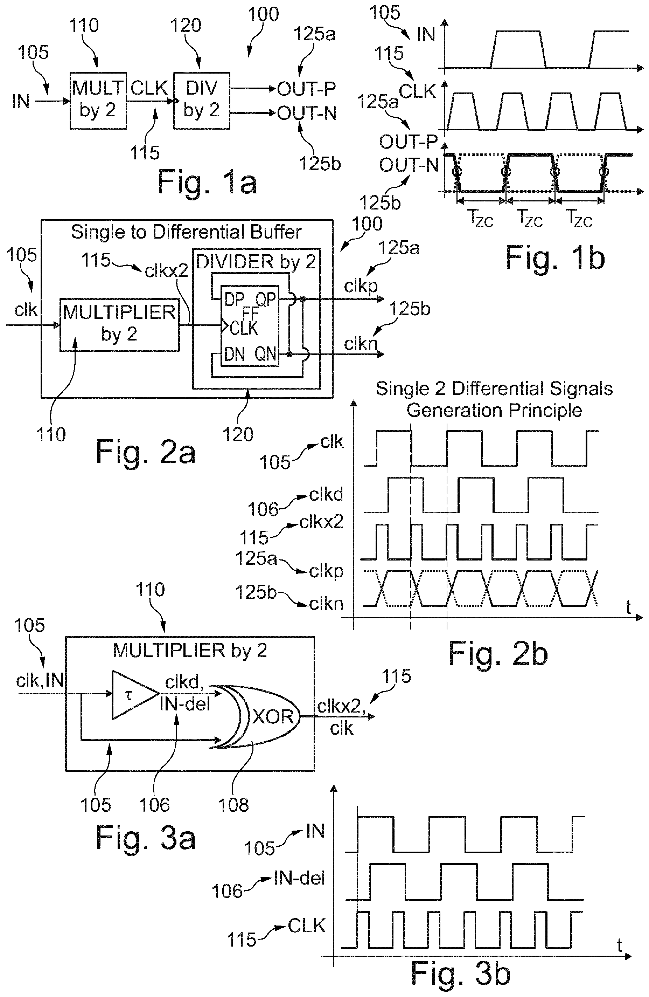

**Figure 1a** illustrates a signal converter device 100 according to an exemplary embodiment of the present disclosure. The signal converter device 100 is configured for converting a single-ended input signal 105 into a differential signal 125. The device 100 comprises a multiplier device 110, configured to receive the single-ended incoming signal 105, and to multiply the incoming signal 105 by two to provide a multiplied signal 115. The device 100 further comprises a divider device 120 downstream of the multiplier device 110, and configured to receive the multiplied signal 115 from the multiplier device 110, and divide the multiplied signal 115 by two to provide the differential signal 125. The differential signal 125 comprises hereby two complementary phases 125a, 125b.

**Figure 1b** illustrates examples of the signals that correspond to the above described signal converter device 100. The multiplied signal 115 (CLK) is double with respect to the incoming signal 105 (IN), while the differential signal 125 is again half of the multiplied signal 115. It can be seen that the two complementary phases 125a, 125b (OUT-P and OUT-N) of the differential signal 125 show perfect zero-crossing properties (see added circles).

**Figure 2a** illustrates a signal converter device 100 as described for Figure 1a above, but in more detail according to an exemplary embodiment of the present disclosure. In this example, the divider device 120 is implemented as a differential symmetrical flip-flop device.

**Figure 2b** illustrates examples of the signals that correspond to the above described signal converter device 100. Like in the case of Figure 1b, the differential signal 125 shows perfect zero-crossing properties. The delayed input signal clkd is described below. The rising edges of the multiplied signal 115 (clkx2) are built with the input signal 105 (clk), which provides a more efficient noise suppression. In this example, only the rising edge is built with the input signal 105, while the falling edge is built with the delayed signal 106. Hereby, only the rising edge is important for noise suppression because the divider 120 is clocked on the rising edge of the multiplied signal 115. Each edge of the divider by two outputs (differential signal 125) is built with a rising edge of the multiplied signal 115 (clkx2).

**Figure 3a** illustrates a multiplier device 110 according to an exemplary embodiment of the present disclosure. The multiplier device 110 comprises a delay-circuit that provides a delayed incoming signal 106 with respect to the incoming signal 105. When performing the multiplication, the incoming signal 105, as well as the delayed incoming signal 106, are taken into account. Specifically, in this example, there is provided an XOR-gate 108, wherein the input to the XOR-gate 108 comprises the incoming signal 105 and the delayed incoming signal 106. As a consequence, the output of the XOR-gate 108 comprises the multiplied signal 115. The accuracy of the delay t is not important in this example. It only defines the accuracy of the falling edge of the clock signal (clk), while the divider device 120 is positive edge triggered (or vice versa).

**Figure 3b** illustrates examples of the signals that correspond to the above described multiplier device 110.

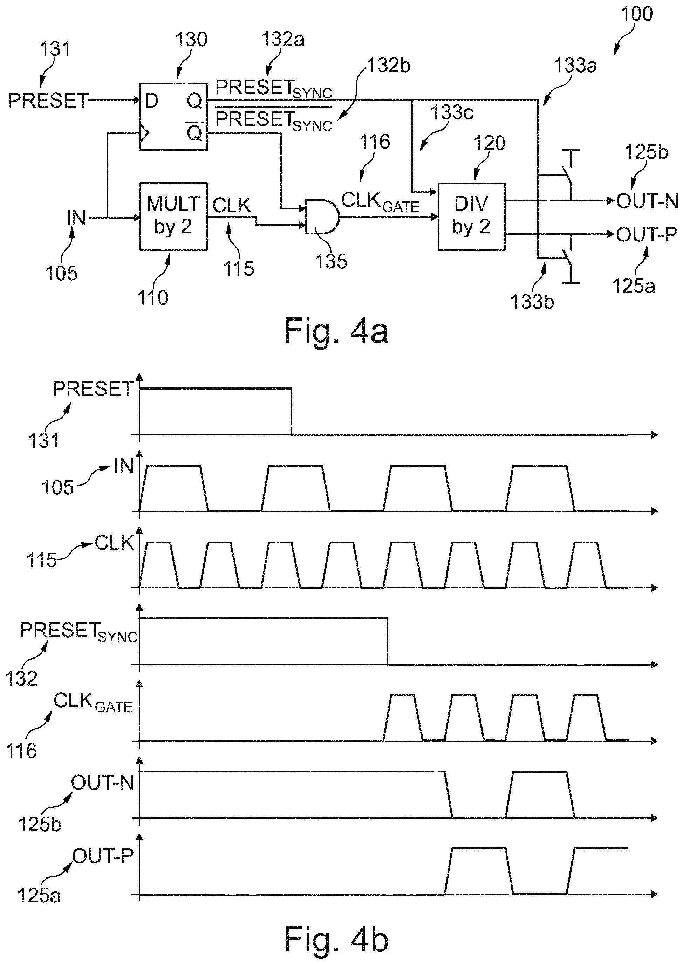

**Figure 4a** illustrates a signal converter device 100 with a synchronization device 130 according to an exemplary embodiment of the present disclosure. The synchronizer device 130 is configured to provide a plurality of synchronization signals 132a, 132b based on an incoming preset signal 131. The synchronization device 130 determines a difference between the incoming signal 105 and the preset signal 131 and provides, based on the result, a first synchronization signal 132a to the differential signal 125, and a second synchronization signal 132b to the multiplied signal 115. Regarding the first synchronization signal 132a, this is divided into two further first synchronization signals 133a,b each of which is applied to synchronize one of the complementary phases 125a, 125b of the differential signal 125. The second synchronization signal 132b is compared/combined with the multiplied signal 115 at a combiner device, e.g. an AND-gate (135), to provide a synchronized multiplied signal 116. The preset release of divider device 120 is synchronized to the input clock by a third synchronization signal 133c.

**Figure 4b** illustrates the signal of the above described signal converter device 100 with the synchronizer device 130. Based on the preset synchronization signal 131, the synchronized multiplied signal 116 and the synchronized differential signal phases 125a, b will be truncated at an initial signal sequences.

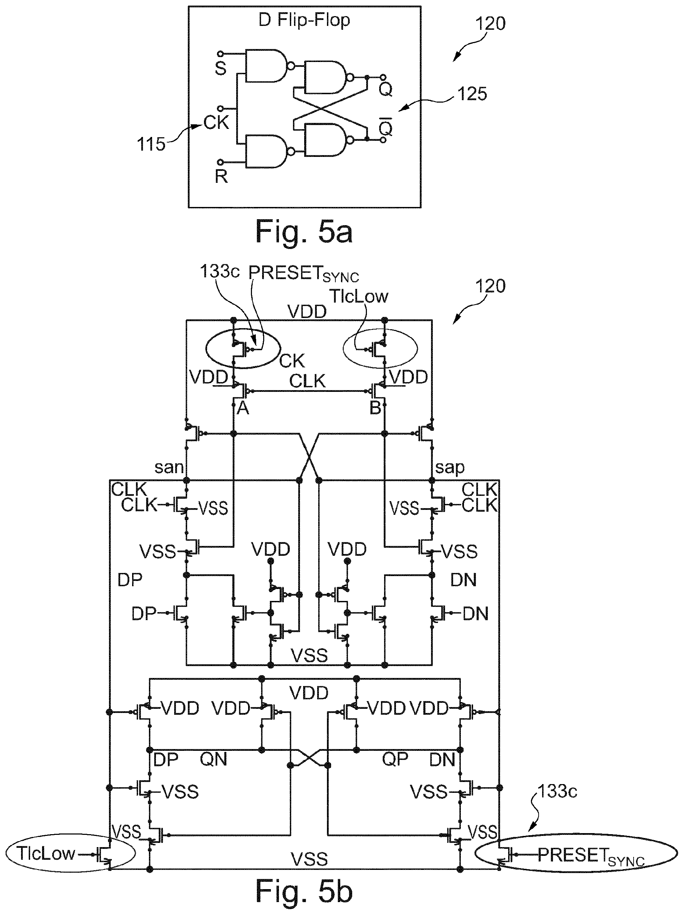

**Figure 5a** illustrates a basic implementation of the divider device 120 using a differential symmetrical flip-flop circuit according to an exemplary embodiment of the present disclosure.

**Figure 5b** illustrates a more detailed implementation of the divider device 120 with a synchronizer device 130 according to an exemplary embodiment of the present disclosure. Specifically, there is shown an example at transistor level based on a sense-amplifier-based D-flip-flop, which is differential and perfectly symmetrical. The synchronized preset signal 133c is applied to the left upper-most transistor (see circle). Then, a pull-down nMOS forces the internal node A to the logic level low and the outputs QP to the logic level high. The right lower-most pMOS (see circle) is off, thereby ensuring that the node A can go to logic level low reliably. The logic level high on QP naturally forced a logic level low on QN (and a logic level high on internal node B). The right upper-most transistor (see circle) is optional for the preset functionality, but is used to ensure a complete symmetric design (the pMOS is always active, the nMOS is always off).

**Figure 6** illustrates the transfer function of a TDC (the phase difference of its two incoming signals is digitized) in an ideal situation (linear behavior) and in a real case, when non-idealities in the circuit cause non-linearities in the transfer function. Ensuring a highly stable zero-crossing (see also Figure 7b) provides a transfer function that is more linear.

### REFERENCE NUMERALS

- 100: Signal converter device
- 105: Incoming single-ended signal
- 106: Delayed incoming signal
- 108: XOR-gate
- 110: Multiplier device
- 115: Multiplied signal
- 116: Synchronized multiplied signal
- 120: Divider device
- 125: Divided differential signal
- 125a,b: Divided differential signals
- 130: Synchronization device
- 131: Preset signal
- 132a: First synchronization signal for differential signal
- 132b: Second synchronization signal for multiplied signal
- 133a,b,c: Further synchronization signals
- 135: Combiner, AND-gate

## Claims

1. A signal converter device (100) for converting a single-ended signal to a differential signal, the device (100) comprising:
a multiplier device (110), configured to receive a single-ended incoming signal (105), and multiply the incoming signal (105) to provide a multiplied signal (115), wherein the multiplication is a frequency multiplication; and
a divider device (120), configured to receive the multiplied signal (115), and divide the multiplied signal (115) to provide a differential signal (125a, 125b), wherein the division is a frequency division;
**characterized in that** the device further comprises:
a synchronizer device (130) configured to provide a preset signal (131), and synchronize at least one of the multiplied signal (115) and the differential signal (125) with respect to the preset signal (131).

2. The signal converter device (100) according to claim 1,
wherein the multiplier device (110) is configured to multiply by two or a multiple of two.

3. The signal converter device (100) according to claim 1 or 2,
wherein the divider device (120) is configured to divide by two or the multiple of two.

4. The signal converter device (100) according to any one of the preceding claims,
wherein at least one of the incoming signal (105) and the multiplied signal (115) is a clock signal.

5. The signal converter device (100) according to any one of the preceding claims,
wherein the multiplier device (110) is further configured to
provide a delayed incoming signal (106) of the incoming signal (105), and
include a delayed incoming signal (106) in the multiplication.

6. The signal converter device (100) according to claim 5,
wherein the multiplier device (110) further comprises an XOR-gate (108),
wherein the input to the XOR-gate (108) comprises the incoming signal (105) and the delayed incoming signal (106), and
wherein the output of the XOR-gate (108) comprises the multiplied signal (115).

7. The signal converter device (100) according to any one of the preceding claims,
wherein the divider device (120) comprises a differential flip-flop circuit.

8. The signal converter device (100) according to claim 7, wherein the differential flip-flop circuit is configured as a symmetrical differential flip-flop circuit.

9. The signal converter device (100) according to any one of the preceding claims,
wherein the device (100) is at least partially configured in CMOS.

10. The signal converter device (100) according to any one of the preceding claims, further comprising:
a combiner, coupled in between the multiplier device (110) and the divider device (120);
wherein the synchronizer device (130) is configured to provide a synchronization signal (132b) to the combiner (135) to generate a synchronized multiplied signal (116).

11. The signal converter device (100) according to claim 10,
wherein the combiner comprises or consists of an AND-gate (135).

12. A time-to-digital converter that comprises the device (100) according to any one of the preceding claims.

13. A method of converting a single-ended signal to a differential signal, the method comprising:
receiving a single-ended incoming signal (105);
multiplying the incoming signal (105) to provide a multiplied signal (115), wherein the multiplication is a frequency multiplication; and subsequently
dividing the multiplied signal (115) to provide a differential signal (125a, 125b), wherein the division is a frequency division;
**characterized by**
providing a preset signal (131), and
synchronizing at least one of the multiplied signal (115) and the differential signal (125) with respect to the preset signal (131).

## Patentansprüche

1. Signalwandlervorrichtung (100) zum Umwandeln eines unsymmetrischen Signals in ein Differenzsignal, wobei die Vorrichtung (100) Folgendes umfasst:
eine Multiplizierervorrichtung (110), die dazu konfiguriert ist
ein unsymmetrisches eingehendes Signal (105) zu empfangen, und
das eingehende Signal (105) zu multiplizieren, um ein multipliziertes Signal (115) bereitzustellen, wobei die Multiplikation eine Frequenzmultiplikation ist; und
eine Teilervorrichtung (120), die dazu konfiguriert ist das multiplizierte Signal (115) zu empfangen, und
das multiplizierte Signal (115) zu teilen, um ein Differenzsignal (125a, 125b) bereitzustellen, wobei die Teilung eine Frequenzteilung ist;
**dadurch gekennzeichnet, dass** die Vorrichtung ferner Folgendes umfasst:
eine Synchronisiervorrichtung (130), die dazu konfiguriert ist, ein voreingestelltes Signal (131) bereitzustellen und das multiplizierte Signal (115) und/oder das Differenzsignal (125) mit Bezug auf das voreingestellte Signal (131) zu synchronisieren.

2. Signalwandlervorrichtung (100) nach Anspruch 1,
wobei die Multiplizierervorrichtung (110) dazu konfiguriert ist, mit zwei oder einem Vielfachen von zwei zu multiplizieren.

3. Signalwandlervorrichtung (100) nach Anspruch 1 oder 2,
wobei die Teilervorrichtung (120) dazu konfiguriert ist, sich durch zwei oder das Vielfache von zwei zu teilen.

4. Signalwandlervorrichtung (100) nach einem der vorhergehenden Ansprüche,
wobei das eingehende Signal (105) und/oder das multiplizierte Signal (115) ein Taktsignal ist.

5. Signalwandlervorrichtung (100) nach einem der vorhergehenden Ansprüche,
wobei die Multiplizierervorrichtung (110) ferner dazu konfiguriert ist:
ein verzögertes eingehendes Signal (106) des eingehenden Signals (105) bereitzustellen, und
ein verzögertes eingehendes Signal (106) in die Multiplikation einzubeziehen.

6. Signalwandlervorrichtung (100) nach Anspruch 5,
wobei die Multiplizierervorrichtung (110) ferner ein XOR-Gatter (108) umfasst,
wobei die Eingabe in das XOR-Gatter (108) das eingehende Signal (105) und das verzögerte eingehende Signal (106) umfasst, und
wobei die Ausgabe des XOR-Gatters (108) das multiplizierte Signal (115) umfasst.

7. Signalwandlervorrichtung (100) nach einem der vorhergehenden Ansprüche,
wobei die Teilervorrichtung (120) eine differenzielle Flip-Flop-Schaltung umfasst.

8. Signalwandlervorrichtung (100) nach Anspruch 7, wobei die differenzielle Flip-Flop-Schaltung als eine symmetrische differenzielle Flip-Flop-Schaltung konfiguriert ist.

9. Signalwandlervorrichtung (100) nach einem der vorhergehenden Ansprüche, wobei die Vorrichtung (100) zumindest teilweise in CMOS konfiguriert ist.

10. Signalwandlervorrichtung (100) nach einem der vorhergehenden Ansprüche, die ferner Folgendes umfasst:
einen Kombinierer, der zwischen die Multiplizierervorrichtung (110) und die Teilervorrichtung (120) gekoppelt ist;
wobei die Synchronisiervorrichtung (130) dazu konfiguriert ist, dem Kombinierer (135) ein Synchronisationssignal (132b) bereitzustellen, um ein synchronisiertes multipliziertes Signal (116) zu erzeugen.

11. Signalwandlervorrichtung (100) nach Anspruch 10,
wobei der Kombinierer ein UND-Gatter (135) umfasst oder daraus besteht.

12. Zeit-Digital-Wandler, der die Vorrichtung (100) nach einem der vorhergehenden Ansprüche umfasst.

13. Verfahren zum Umwandeln eines unsymmetrischen Signals in ein Differenzsignal, wobei das Verfahren Folgendes umfasst:
Empfangen eines unsymmetrischen eingehenden Signals (105);
Multiplizieren des eingehenden Signals (105), um ein multipliziertes Signal (115) bereitzustellen, wobei die Multiplikation eine Frequenzmultiplikation ist; und anschließend
Teilen des multiplizierten Signals (115), um ein Differenzsignal (125a, 125b) bereitzustellen, wobei die Teilung eine Frequenzteilung ist;
**gekennzeichnet durch** Bereitstellen eines voreingestellten Signals (131) und Synchronisieren des multiplizierten Signals (115) und/oder des Differenzsignals (125) mit Bezug auf das voreingestellte Signal (131).

## Revendications

1. Dispositif convertisseur de signal (100) pour la conversion d'un signal asymétrique en un signal différentiel, le dispositif (100) comprenant :
un dispositif multiplicateur (110), configuré pour recevoir un signal entrant asymétrique (105), et
multiplier le signal entrant (105) pour fournir un signal multiplié (115), la multiplication étant une multiplication fréquentielle ; et
un dispositif diviseur (120), configuré pour recevoir le signal multiplié (115), et
diviser le signal multiplié (115) pour fournir un signal différentiel (125a, 125b), la division étant une division fréquentielle ;
le dispositif étant **caractérisé en ce qu'**il comprend en outre :
un dispositif synchroniseur (130) configuré pour fournir un signal de présélection (131) et synchroniser au moins un signal parmi le signal multiplié (115) et le signal différentiel (125) par rapport au signal de présélection (131).

2. Dispositif convertisseur de signal (100) selon la revendication 1,
dans lequel le dispositif multiplicateur (110) est configuré pour multiplier par deux ou un multiple de deux.

3. Dispositif convertisseur de signal (100) selon la revendication 1 ou 2,
dans lequel le dispositif diviseur (120) est configuré pour diviser par deux ou le multiple de deux.

4. Dispositif convertisseur de signal (100) selon l'une quelconque des revendications précédentes,
dans lequel au moins un signal parmi le signal entrant (105) et le signal multiplié (115) est un signal d'horloge.

5. Dispositif convertisseur de signal (100) selon l'une quelconque des revendications précédentes,
dans lequel le dispositif multiplicateur (110) est en outre configuré pour
fournir un signal entrant retardé (106) du signal entrant (105), et
inclure un signal entrant retardé (106) dans la multiplication.

6. Dispositif convertisseur de signal (100) selon la revendication 5,
dans lequel le dispositif multiplicateur (110) comprend en outre une porte OU exclusif (108),
dans lequel l'entrée de la porte OU exclusif (108) comprend le signal entrant (105) et le signal entrant retardé (106), et
dans lequel la sortie de la porte OU exclusif (108) comprend le signal multiplié (115).

7. Dispositif convertisseur de signal (100) selon l'une quelconque des revendications précédentes,
dans lequel le dispositif diviseur (120) comprend un circuit de bascule différentielle.

8. Dispositif convertisseur de signal (100) selon la revendication 7, dans lequel le circuit de bascule différentielle est configuré sous forme d'un circuit de bascule différentielle symétrique.

9. Dispositif convertisseur de signal (100) selon l'une quelconque des revendications précédentes, le dispositif (100) étant au moins partiellement réalisé en technologie CMOS.

10. Dispositif convertisseur de signal (100) selon l'une quelconque des revendications précédentes, comprenant en outre :
un combineur, couplé entre le dispositif multiplicateur (110) et le dispositif diviseur (120) ;
dans lequel le dispositif synchroniseur (130) est configuré pour fournir un signal de synchronisation (132b) au combineur (135) pour générer un signal multiplié synchronisé (116).

11. Dispositif convertisseur de signal (100) selon la revendication 10,
dans lequel le combineur comprend ou consiste en une porte ET (135).

12. Convertisseur temps-numérique qui comprend le dispositif (100) selon l'une quelconque des revendications précédentes.

13. Procédé de conversion d'un signal asymétrique en un signal différentiel, le procédé comprenant :
la réception d'un signal entrant asymétrique (105) ;
la multiplication du signal entrant (105) pour fournir un signal multiplié (115), la multiplication étant une multiplication fréquentielle ; et, par la suite,
la division du signal multiplié (115) pour fournir un signal différentiel (125a, 125b), la division étant une division fréquentielle ;
**caractérisé par** la fourniture d'un signal de présélection (131), et la synchronisation d'au moins un signal parmi le signal multiplié (115) et le signal différentiel (125) par rapport au signal de présélection (131).
